# EUROPÄISCHE PATENTANMELDUNG

(11) **EP 2 166 130 A1**
(43) Veröffentlichungstag der Anmeldung: **24.03.2010**
(21) Anmeldenummer: 08405229.9
(22) Anmeldetag: 17.09.2008
(51) Int. Cl.: C23C 16/26, B65D 25/34

(54) **Kunststoffilm mit guter Barrierewirkung nach einer Sterilisierbehandlung**

(71) Anmelder: Alcan Technology & Management Ltd., 8212 Neuhausen am Rheinfall (CH)
(72) Erfinder: Körner, Lutz, 8057 Zürich (CH); Sonnenfeld, Axel, 8055 Zürich (CH); Rudolf von Rohr, Phillipp, 4132 Muttenz (CH)

(57) **Zusammenfassung**

Ein Kunststoffflim für Verpackungezwecke, mit guter Durchtrittssperrwirkung gegenüber Gasen, Wasserdampf und Aromastoffen nach einer Sterilisierbehandlung, weist eine durch Plasma unterstützte chemische Gasphasenabscheidung (PECVD) erzeugte Sperrschicht aus amorphem hydriertem und mit Stickstoff (N) dotiertem Kohlenstoff (a-C:N:H) auf.

## Beschreibung

Die Erfindung betrifft einen Kunststofffilm für Verpackungszwecke, mit guter Durchtrittssperrwirkung gegenüber Gasen, Wasserdampf und Aromastoffen nach einer Sterilisierbehandlung, wobei der Kunststofffilm eine durch Plasma unterstützte chemische Gasphasenabscheidung (PECVD) erzeugte Sperrschicht aus amorphem hydriertem Kohlenstoff (a-C:H) aufweist. Im Rahmen der Erfindung liegt auch ein zur Herstellung der Sperrschicht auf dem Kunststofffilm geeignetes Verfahren.

Bekannte sterilisierbare Verpackungsmaterialien mit guten Barrierewirkung nach einer Sterilisierbehandlung bestehen aus ein- oder mehrschichtigen Kunststofffllmen und einer wasserdampf- und gasundurchlässigen Sperrschicht in Form einer Aluminiumfolie. Metallfolien eignen sich ausgezeichnet für sterilislerbare Verpackungsmaterialien und weisen zudem ausgezeichnete Barriereelgenschaften auf. Aus verschiedenen Gründen werden Jedoch heute zunehmend transparente Verpackungen verlangt, welche mit Metallfolien als Sperrschichten nicht zu erreichen sind.

Bekannte transparente Verpackungsmaterialien mit Sperrelgenschaften bestehen aus mehrschichtigen Kunststofffilmen, wobei einer der Kunststofffilme eine Oxidschicht, z.B. In der Form von SiOₓ, als Barriereschicht aufweist. Andere bekannte und zur Verpackung von Lebensmitteln eingesetzte transparente Verpackungsfilme weisen als Barriereschicht einen Film aus Polyvinylidenchlorid (PVDC) oder Ethylen-Vinylalkohol Copolymer (EVOH) auf. Die thermische Beanspruchung dieser transparenten Verpackungsmaterialien während der Sterilisation führt jedoch in der Regel zu einer Verschlechterung der Barriereeigenschaften. Besonders unter extremen Sterilisationsbedlngungen kann eine massive, irreversible Beeinträchtigung der Sperrwirkung auftreten. So kann z.B. die Zunahme der Sauerstoffdurchlässigkelt eines herkömmlichen steriiisierbaren Verpackungsfllms unter extremen Sterilisationsbedingungen um einen Faktor 3 bis 20 betragen.

Aus US 2005/0003124 A1 ist eine durch Plasma unterstützte chemische Gasphasenabscheldung (PECVD, plasma enhanced chemical vapour deposition) auf ein Polymersubstrat aufgedampfte Barriereschicht aus SiOₓ mit x zwischen 1.5 und 2.3 bekannt. Die Barriereschicht aus SiOₓ ist mit einer Schutzschicht aus amorphem hydriertem Kohlenstoff (a-C:H) versehen. Der hydrierte Kohlenstofffilm dient dazu, die bei Deformationen des Polymersubstrats auftretenden Mikrorisse in der Barriereschicht aus SiOₓ zu verhindern. Die Abscheidung der Schutzschicht aus a-C:H erfolgt durch PECVD einer Kohlenwasserstoffverbindung, bevorzugt Acetylen. Die Abscheldung der Barriereschicht aus SiOₓ erfolgt durch PECVD einer organischen Siliziumverbindung in Gegenwart eines Sauerstoffüberschusses. Vor der Abscheidung der Barriereschicht aus SiOₓ kann auf dem Polymersubstrat eine Zwischenschicht aus einer Mischung von Silicium, Kohlenstoff, Sauerstoff, Stickstoff und Wasserstoff abgeschleden werden. Ausgangsmaterialien sind z.B. Disiloxane, wie Hexamethyldisiloxan (HMDSO) oder Tstramethyldisiloxan (TMDSO). Es kann ein Trägergas, bevorzugt Stickstoff, verwendet werden. Das beschichtete Polymersubstrat betrifft insbesondere Flaschen aus Polyethylenterephthalat (PET). Die auf der Innenseite beschichteten Flaschen werden zur Verpackung von sauerstoffempfindlichen Produkten, wie z.B. Bier, Fruchtsäfte und stark kohlensäurehaltige Getränke, verwendet.

JP 2008/094447 A offenbart einen Kunststoffbahälter mit ausgezeichneten Gasbarriereeigenschaften. Auf der Kunststoffoberfläche ist ein erster, durch PECVD abgeschiedener Film aus a-C:H angeordnet. Auf dieser ersten Schicht Ist eine ebenfalls durch PECVD erzeugte zweite Schicht aus Siliziumoxid abgeschieden. Als Prozessgas zur Bildung des Kohlenstoffflims wird Acetylen bevorzugt eingesetzt. Es können Jedoch auch stickstoffhaltige Kohlenstoffverbindungen zur Bildung des Kohlenstofffilms verwendet werden. Zur Bildung des Siliziumoxidfilms ist eine Mischung von Hexamethydisiloxan und Sauerstoff als Prozessgas bevorzugt. Der beschriebene Kunststoffbehälter ist eine Innen beschichtete Flasche und dient zur Verpackung von Getränken.

Aus JP 2004/314407 A ist ein aus zwei PET-Filmen mit einem dazwischen liegenden Film aus hydriertem Kohlenstoff (a-C:H) bestehendes Verpackungslaminat mit ausgezeichneten Gasbarriereeigenschaften bekannt. Bei der Herstellung des Laminats wird der hydrierte Kohlenstofffilm durch PECVD mit Acetylen als Prozessgas auf einem ersten Kunststofffilm abgeschieden. Nachfolgend wird der beschichtete erste Kunststofffilm mit einem zweiten, mit einem Klebstoff beschichteten PET-Film laminiert. Der zweite Kunststofffilm schützt den hydrierten Kohlenstofffilm vor Beschädigung und Delamination. Die Kunststofffilme können aus einem Polyester, einem Polyamid oder einem Polyolefin bestehen. Es wurde beobachtet, dass die Sauerstoffdurchlässigkelt des amorphen Kohlenstofffilms mit zunehmender Dotlerung des Kohlestofffilms mit Sauerstoff und Stickstoff abnimmt. Eine ungewollte Dotierung mit Stickstoff und Sauerstoff kann beispielsweise bei ungenügender Entfernung von Luft aus der Beschichtungsapparatur oder durch Undichtigkelt der Apparatur auftreten. Es soll deshalb darauf geachtet werden, dass auf 100 Kohlenstoffatome im amorphem Kohlenstofffilm höchstens 15 Stickstoffatome und höchstens 20 Sauerstoffatome entfallen, insgesamt jedoch nicht mehr als 27 Stickstoff- und Sauerstoffatome pro 100 Kohlenstoffatome. Das mit einer Gasbarriere ausgestattete Verpackungsiaminat soll u.a. zur Verpackung von Getränken, Lebensmittein, Medikamenten Kosmetika geeignet sein.

Der Erfindung liegt die Aufgabe zu Grunde, einen Kunststofffilm der eingangs genannten Art mit verbesserter Temperaturbeständigkeit für Sterilisieranwendungen bereitzustellen.

Zur erfindungsgemässen Lösung der Aufgabe führt, dass die Sperrschicht aus amorphem hydriertem Kohlenstoff (a-C;N:H) mit Stickstoff (N) dotiert ist.

Auf der Sperrschicht aus amorphem hydriertem und mit Stickstoff (N) dotiertem Kohlenstoff (a-C:N:H) kann eine zweite Sperrschicht aus einem Metall, einem Metalloxid oder einem Metallnitrid angeordnet sein. Diese zweite Sperrschicht Ist beispielsweise eine keramische Dünnschicht, Insbesondere ein Siliziumoxid der Formel SiOₓ, wobei x eine Zahl von 1 bis 2 ist, oder ein Aluminiumoxid der Formel Al_{y}O_{z}, wobei y/z eine Zahl von 0,2 bis 1,5 darstellt, oder eine Mischung daraus. Die keramische Dünnschicht kann neben den genannten Silizium- und Aluminiumoxiden ferner auch Oxide und/oder Nitride von Metallen und/oder Halbmetallen, z.B. diejenigen des Eisens, Nickels, Chroms, Tantals, Molybdäns, Hafniums, Titans, Yttriums, Zirkons, Magnesiums sowie Mischungen dieser Substanzen enthalten oder daraus bestehen. Weiter mögliche zweite Sperrschichten können als Metall auf dem Substrat abgeschieden werden. Bevorzugte Metalle sind Al, Zn, Sn, Ag oder Tl. Als Metalloxidbarriereschichten können neben den vorstehend erwähnten Silizium- und Aluminiumoxiden auch die Oxide der weiter genannten Metalle verwendet werden, beispielsweise SnO₂, ZnO oder Mischungen davon, auch mit SiOₓ. Bevorzugt wird jedoch die vorstehend erwähnte Sperrschicht aus SiOₓ, die auch durch PECVD aus einer Mischung von HMDSO und O₂ abgeschieden werden kann.

Die zweite Sperrschicht kann beispielsweise durch ein Vakuumdünnschlchtverfahren, wie physikalische Beschlchtungsverfahren (PVD-Verfahren) oder chemische Beschichtungsverfahren (CVD-Verfahren) mit und ohne Plasmaunterstützung, oder durch Sputtern aufgebracht werden. Bevorzugt werden physikalische Beschichtungsverfahren, insbesondere auf der Basis von Elektronenstrahlverdampfen.

Zwischen der Sperrschicht aus amorphem hydriertem und mit Stickstoff dotiertem Kohlenstoff (a-C:N:H) und der zweiten Sperrschicht aus einem Metall, elnem Metalloxid oder einem Metallnitrid kann eine weitere Sperrschicht aus amorphem hydriertem und mit Stickstoff und Silizium (Si) dotiertem Kohlenstoff (a-C:N:Si:H) als Zwischenschicht angeordnet sein.

Bei einem zur Herstellung des erfindungsgemässen Kunststofffilms geeigneten Verfahren wird aus einer Mischung einer gasförmigen Kohlenstoff- und einer gasförmigen Stickstoffquelle als Prozessgas durch PECVD eine Sperrschicht aus amorphem hydriertem und mit Stickstoff (N) dotiertem Kohlenstoff (a-C:N:H) erzeugt.

Bevorzugt wird eine Mischung aus Acetylen (C₂H₂) und Stickstoff (N₂) als Prozessgas verwendet.

Für eine optimale Sauerstoffbarrierewirkung wird das volumetrische Mischungsverhältnis von Stickstoff (N₂) zu Acetylen (C₂H₂) im Prozessgas auf elnen Wert von 3 bis 19, vorzugsweise 6 bis 8, eingestellt.

Auf der Sperrschicht aus amorphem hydriertem und mit Stickstoff (N) dotiertem Kohlenstoff (a-C:N:H) kann eine zweite Sperrschicht aus einem Metall, einem Metalloxid oder einem Metallnitrid erzeugt werden. Die zweite Sperrschicht kann auch aus einer Mischung von Hexamethyldisiloxan (HMDSO) und Sauerstoff (O₂) als Prozessgas durch PECVD eine zweite Sperrschicht aus Siliziumoxid (SiOₓ) erzeugt werden.

Zwischen der Sperrschicht aus amorphem hydriertem und mit Stickstoff (N) dotiertem Kohlenstoff (a-C:N:H) und der zweiten Sperrschicht aus einem Metall, einem Metalloxid oder einem Metallnitrid kann aus einer Mischung von Hexamethyldisiloxan (HMDSO), Acetylen (C₂H₂) und Stickstoff (N₂) als Prozessgas eine weitere Sperrschicht aus amorphem hydriertem und mit Stickstoff (N) und Silizium (Si) dotiertem Kohlenstoff (a-C:N:Si:H) als Zwischenschicht erzeugt werden.

Als Kunststofffilme können alle ein oder mehrschichtigen, zur Verpackung geeigneten Kunststofffilme verwendet werden. Dies sind insbesondere Filme aus Polyolefinen, wie Polypropylen (PP) und Polyethylen (PE), Polyamid (PA), Polyester, insbesondere Polyethylenterephthalat (PET), in der Form von Mono- oder Mehrschichtfilmen.

Bevorzugtes Anwendungsgebiet des erfindungsgemässen Kunststofffllms sind Verpackungen, insbesondere In der Form von Behältern und Beuteln aller Art für sauerstoffempfindilche Produkte aus dem Food- und Nonfood-Bereich.

Weitere Vorteile, Merkmale und Einzelheiten der Erfindung ergeben sich aus der nachfolgenden Beschreibung bevorzugter Ausführungsbeispiele, sowie anhand der Zeichnung; diese zeigt In
- Fig. 1: ATR/FTIR-Spektren von verschiedenen Kohlenstoffbeschlchtungen auf einem Substrat aus Polypropylen;
- Fig. 2: die Sauerstoffdurchlässlgkelt von Substraten mit unterschledlicher Beschichtung vor und nach einer Sterilisierbehandlung;
- Fig. 3: die Abhängigkeit der Sauerstoffdurchlässigkeit von amorphen hydrierten Kohlenstofffilmen von der Prozessgasmlschung.

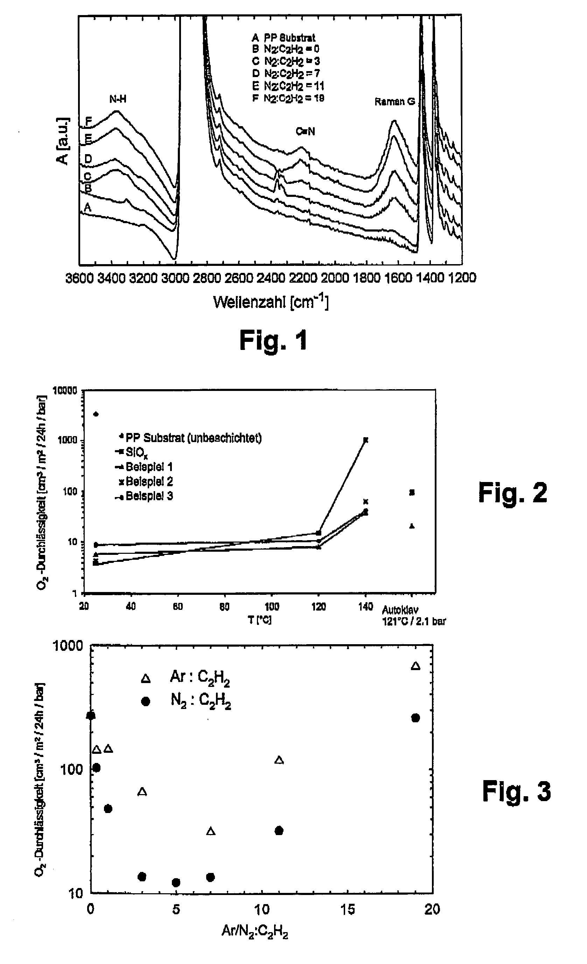

Fig. 1 zeigt ATR/FTIR-Spektren von unterschiedlichen Beschichtungen aus a-C:N:H auf einem Polypropylensubstrat. Die Beschichtungen wurden durch PECVD auf das Substrat abgeschieden. Als Prozessgas wurden Mischungen von Acetylen (C₂H₂) und Stickstoff (N₂) mit einem volumetrischen Mischungsverhältnis von Stickstoff zu Acetylen (N₂: C₂H₂) im Prozessgas von 3 bis 19 verwendet.

Die Spektren lassen sich wie folgt interpretieren: Die starken Absorptionsbänder bei den Wellenzahlen 1360 cm⁻¹, 1450 cm⁻¹, 2913 cm⁻¹ und 2966 cm⁻¹ können C-H-Absorptionsbändem des Polypropylensubstrats zugeschrieben werden. Bei einer Wellenzahl von 1600 cm⁻¹ kann ein mit steigendem Mischungsverhältnis N₂:C₂H₂ im Prozessgas zunehmendes Absorptionsband beobachtet werden. Das Band kann dem Raman G Band zugeschrieben werden, welches durch eine Änderung in der Ladungsvertellungssymmetrie durch die Bildung der C=N Bindung hervorgerufen wird. Bei einer Wellenzahl von 2200 cm⁻¹ wird ein schmäleres, den Nitrilgruppen zuzuordnendes Band beobachtet, welches ebenfalls mit steigendem Stickstoffgehalt ansteigt. Ein weiteres, breiteres Absorptionsband im Bereich von 3300-3500 cm⁻¹ ist charakteristisch für die N-H Streckschwingung. Die beiden letzten sind endständige Gruppen und reduzieren den Grad der Überkoordination im amorphen Kohlenstoffnetzwerk und reduzieren deshalb die innere Spannung in der Beschichtung.

Zur Beschichtung von Substraten mittels Plasma unterstützter Gasphasenabscheidung (PECVD) stand eine mit einem 13.56 Mhz RF Plasmagenerator ausgestattete Laboranlage mit kapazitiv gekoppelter Elektrode mit einem Durchmesser von 140 mm zur Verfügung. Als Substratmaterial diente ein 30 µm dlcker Polypropylenfilm, der zur Durchführung der Beschichtungen auf der Elektrode platziert wurde.

### Beispiel 1

Es wurden übereinander eine erste Schicht aus a-C:N:H, eine zweite Schicht aus a-C:N:Si:H und eine dritte Schicht aus SiOₓ durch PECVD auf den Polypropylenfilm aufgedampft. Als Prozessgase wurde für die erste Schicht eine Mischung von Acetylen und Stickstoff, für die als Zwischenschicht dienende zweite Schicht eine Mischung von Acetylen, Stickstoff und HMDSO eingesetzt. Die Prozessparameter sind aus Tabelle 1 ersichtlich.

**Tabelle 1: Prozessparameter für Beispiel 1**

| **Prozessparameter** | **Schicht 1 a-C:N:H** | **Schicht 2 a-C:N:Si:H** | **Schicht 3 SiOₓ** |
|---|---|---|---|
| RF Leistung [W] | 50 | 75 | 100 |
| Prozessdruck [mbar] | 0.1 | 0.1 | 0.1 |
| C₂H₂ Durchflussrate [sccm] | 7.5 | 3 | - |
| HDMSO Durchflussrate [sccm] | - | 2 | 2 |
| N₂ Durchflussrate [sccm] | 52.5 | 55 | - |
| O₂ Durchflussrate [sccm] | - | - | 60 |
| Abscheldungszeit [s] | 3 x 4 | 3 x 4 | 15 x 4 |
| Schichtdicke [nm] | ca. 18 | 45 | 190 |
| Self-bias U_{b} [V] | -225 | -274 | -362 |

Die bei 25°C gemessene Sauerstoffdurchlässigkeit des beschichteten Substrats betrug 5 cm³/m²/24h/bar. Vergleichsweise liegt der entsprechende Wert für das unbeschichtete Substrat bei etwa 3000 cm³/m²/24h/bar. Die hervorragenden Barriereelgenschaften des mit drei Schichten beschichteten Substrats unter Trockensterilisationsbedingungen bei 120 °C und 140 °C während 30 Min. sowie eine Sterilisation im Autoklaven bei 121 °C und 2.1 bar während 30 Min. Im Vergleich zu den Barriereeigenschaften eines nur mit SiOₓ gleicher Dicke beschichteten Substrats ergeben sich aus der Betrachtung der Fig. 2.

### Beispiel 2

Es wurden übereinander eine erste Schicht aus a-C:N:H und eine zweite Schicht aus SiOₓ durch PECVD auf den Polypropylenfilm aufgedampft. Als Prozessgase wurde für gleiche Schichten die gleichen Mischung wie in Beispiel 1 verwendet. Die Prozessparameter sind aus Tabelle 2 ersichtlich.

**Tabelle 2: Prozessparameter für Beispiel 2**

| **Prozessparameter** | **Schicht 1** **a-C:N:H** | **Schicht 2** **SiOₓ** |
|---|---|---|
| RF Leistung [W] | 50 | 100 |
| Prozessdruck [mbar] | 0.1 | 0.1 |
| C₂H₂ Durchflussrate [sccm] | 7.5 | - |
| HDMSO Durchflussrate [sccm] | - | 2 |
| N₂ Durchflussrate [sccm] | 52.5 | - |
| O₂ Durchflussrate [sccm] | - | 60 |
| Abscheldungszeit [s] | 6 x 4 | 15 x 4 |
| Schichtdicke [nm] | ca. 35 | 190 |
| Self-bias U_{b} [V] | -225 | -362 |

Wie aus Fig. 2 ersichtlich, zeigt auch das mit zwei Schichten beschichtete Substrat unter Trockensterilisationsbedingungen bei 120 °C und 140 °C während 30 Min. im Vergleich zu den Barriereeigenschaften eines nur mit SiOₓ gleicher Dicke beschichteten Substrats wesentlich bessere Barriereeigenschaften.

### Beispiel 3

Es wurde lediglich eine einzige Schicht aus a-C:N:H durch PECVD auf den Polypropylenfilm aufgedampft. Als Prozessgase wurde die gleiche Mischung wie für die erste Schicht In Beispiel 1 verwendet. Die Prozessparameter sind aus Tabelle 3 ersichtlich.

**Tabelle 3: Prozessparameter für Beispiel 3**

| **Prozessparameter** | **a-C:N:H** |
|---|---|
| RF Leistung [W] | 60 |
| Prozessdruck [mbar] | 0.1 |
| C₂H₂ Durchflussrate [sccm] | 7.5 |
| HDMSO Durchflussrate [sccm] | - |
| N₂ Durchflussrate [sccm] | 52.5 |
| O₂ Durchflussrate [sccm] | - |
| Abscheidungszeit [s] | 15 x 4 |
| Schichtdicke [nm] | 90 |
| Self-bias U_{b} [V] | -225 |

Die Schicht wies im Vergleich zur ersten Schicht aus a-C:N:H In Beisplei 1 eine etwa fünffache Dicke auf und zeigte eine beträchtliche Braunfärbung, so dass diese beschichtete Substrat nicht für alle Anwendungsbereiche als Verpackung einsetzbar ist.

Wie aus Fig. 2 ersichtlich, zeigt auch das mit nur einer Schicht beschichtete Substrat unter Trockensterilisationsbedingungen bei 140 °C während 30 Min. Im Vergielch zu den Barriereelgenschaften eines nur mit SiOₓ gleicher Dicke beschichteten Substrats wesentlich bessere Barriereeigenschaften.

Aus Fig. 3 ist ersichtlich dass die besten Barriereeigenschaften gegenüber Sauerstoffdurchtritt bei einem volumetrische Mischungsverhältnis von Stickstoff zu Acetylen (N₂ : C₂H₂) im Prozessgas von etwa 3 bis 12, insbesondere von etwa 6 bis 8, erreicht werden.

## Patentansprüche

1. Kunststofffilm für Verpackungszwecke, mit guter Durchtrittssperrwirkung gegenüber Gasen, Wasserdampf und Aromastoffen nach einer Sterilisierbehandlung, wobei der Kunststofffilm eine durch Plasma unterstützte chemische Gasphasenabscheldung (PECVD) erzeugte Sperrschicht aus amorphem hydriertem Kohlenstoff (a-C:H) aufweist,
**dadurch gekennzeichnet,**
**dass** die Sperrschicht aus amorphem hydriertem Kohlenstoff (a-C:N:H) mit Stickstoff (N) dotiert ist.

2. Kunststoffilm nach Anspruch 1, **dadurch gekennzeichnet, dass** auf der Sperrschicht aus amorphem hydriertem und mit Stickstoff (N) dotiertem Kohlenstoff (a-C:N:H) eine zweite Sperrschicht aus Metallen, Metalloxiden, vorzugsweise Siliziumoxid (SiOₓ), oder Metallnitriden angeordnet ist.

3. Kunststofffilm nach Anspruch 2, **dadurch gekennzeichnet, dass** zwischen der Sperrschicht aus amorphem hydriertem und mit Stickstoff (N) dotiertem Kohlenstoff (a-C:N:H) und der zweiten Sperrschicht aus Metallen, Metalloxiden oder Metallnitriden eine weitere Sperrschicht aus amorphem hydriertem und mit Stickstoff (N) und Silizium (Si) dotiertem Kohlenstoff (a-C:N:Si:H) als Zwischenschicht angeordnet ist.

4. Verfahren zur Herstellung eines Kunststofffilms für Verpackungszwecke, mit guter Durchtrittssperrwirkung gegenüber Gasen, Wasserdampf und Aromastoffen nach einer Sterilisierbehandlung, wobei der Kunststoffilm eine durch Plasma unterstützte chemische Gasphasenabscheidung (PECVD) erzeugte Sperrschicht aus amorphem hydriertem Kohlenstoff (a-C:H) aufweist,
**dadurch gekennzeichnet, dass** aus einer Mischung einer gasförmigen Kohlenstoff- und einer gasförmigen Stickstoffquelle als Prozessgas durch PECVD eine Sperrschicht aus amorphem hydriertem und mit Stickstoff (N) dotiertem Kohlenstoff (a-C:N:H) erzeugt wird.

5. Verfahren nach Anspruch 2, **dadurch gekennzeichnet, dass** eine Mischung aus Acetylen (C₂H₂) und Stickstoff (N₂) als Prozessgas verwendet wird.

6. Verfahren nach Anspruch 3 **dadurch gekennzeichnet, dass** das volumetrische Mischungsverhältnis von Stickstoff zu Acetylen (N₂ : C₂H₂) im Prozessgas auf einen Wert von 3 bis 19, vorzugsweise 6 bis 8, eingestellt wird.

7. Verfahren nach einem der Ansprüche 4 bis 6, **dadurch gekennzeichnet, dass** auf der Sperrschicht aus amorphem hydriertem und mit Stickstoff (N) dotiertem Kohlenstoff (a-C:N:H) eine zweite Sperrschicht aus Metallen, Metalloxiden, vorzugsweise aus Siliziumoxid (SiOₓ), gegebenenfalls aus einer Mischung von Hexamethyldisiloxan (HMDSO) und Sauerstoff (O₂) als Prozessgas durch PECVD, oder Metalinitriden erzeugt wird.

8. Verfahren nach Anspruch 7, **dadurch gekennzeichnet, dass** zwischen der Sperrschicht aus amorphem hydriertem und mit Stickstoff (N) dotiertem Kohlenstoff (a-C:N:H) und der zweiten Sperrschicht aus Metallen, Metalloxiden oder Metallnitriden aus einer Mischung von Hexamethyldisiloxan (HMDSO), Acetylen (C₂H₂) und Stickstoff (N₂) als Prozessgas eine weitere Sperrschicht aus amorphem hydriertem und mit Stickstoff (N) und Silizium (Si) dotiertem Kohlenstoff (a-C:N:Si:H) als Zwischenschicht erzeugt wird.

9. Verwendung eines nach einem der Ansprüche 1 bis 3 oder eines mit dem Verfahren nach einem der Ansprüche 4 bis 8 hergestellten Kunststofffilms zur Verpackung von sauerstoffempfindlichen Produkten.
